Europäisches Patentamt

European Patent Office

Office européen des brevets

(19)

(11) Veröffentlichungsnummer: **0 162 525**
**B1**

(12) **EUROPÄISCHE PATENTSCHRIFT**

(45) Veröffentlichungstag der Patentschrift: **22.08.90**

(51) Int. Cl.⁵: **H 03 D 3/02**

(21) Anmeldenummer: **85200782.2**

(22) Anmeldetag: **15.05.85**

(54) Schaltungsanordnung zur Verringerung der Verzerrungen bei einem FM-Quadraturdemodulator.

(30) Priorität: **25.05.84 DE 3419602**

(43) Veröffentlichungstag der Anmeldung:
**27.11.85 Patentblatt 85/48**

(45) Bekanntmachung des Hinweises auf die
Patenterteilung:
**22.08.90 Patentblatt 90/34**

(84) Benannte Vertragsstaaten:
**DE FR GB**

(56) Entgegenhaltungen:
**US-A-3 628 046**
**US-A-4 152 665**
**US-A-4 342 000**

**IEEE TRANSACTIONS ON CONSUMER
ELECTRONICS, Band CE-28, Nr. 3, August 1982,
Seiten 383-392, IEEE, New York, US; D. WILE:
"Advanced FM-IF"**
**Idem**

(73) Patentinhaber: **Philips Patentverwaltung GmbH
Wendenstrasse 35 Postfach 10 51 49
D-2000 Hamburg 1 (DE)**
(84) **DE**

(73) Patentinhaber: **N.V. Philips'
Gloeilampenfabrieken
Groenewoudseweg 1
NL-5621 BA Eindhoven (NL)**
(84) **FR GB**

(72) Erfinder: **Jansen, Winfried
Blütenweg 29
D-2081 Ellerbek (DE)**
Erfinder: **Knop, Wilfried
Gärtnerstrasse 2
D-2081 Appen (DE)**
Erfinder: **Jabs, Hermann
Wildgansstrasse 30E
D-2000 Hamburg 73 (DE)**

(74) Vertreter: **Hartmann, Heinrich, Dipl.-Ing. et al
Philips Patentverwaltung GmbH Wendenstrasse
35 Postfach 10 51 49
D-2000 Hamburg 1 (DE)**

## Beschreibung

Die Erfindung bezieht sich auf einen FM-Quadraturdemodulator gemäß dem Oberbegriff des Anspruchs 1. Ein solcher Demodulator ist aus IEEE-Transactions on Consumer Electronics, Band CE-28, Nr. 3, August 1982, Seiten 383—392, New-York, US; D. Wile: "Advanced FM-IF" bekannt. Der FM-Quadraturdemodulator enthält dabei eine Multiplizierstufe, der die beiden Eingangssignale mit einer frequenzabhängigen Phasenverschiebung zugeführt werden und deren Gleichstrom zur Verringerung der Verzerrungen in Abhängigkeit von der Abweichung von der Mittenfrequenz mittels einer Gleichstrom-Rückführung leicht vergrößert wird.

Aufgabe der vorliegenden Erfindung ist die Schaffung einer Schaltungsanordnung zur Verringerung der Verzerrungen bei einem FM-Quadraturdemodulator, die ohne eine solche Rückführung auskommt. Dies Aufgabe wird erfindungsgemäß durch die im Kennzeichen des Anspruchs 1 angegebenen Maßnahmen gelöst.

Die durch die nichtlineare Phasenkennlinie des Schwingkreises bewirkte Verformung, die das Ausgangssignal bei der Demodulation in dem FM-Quadraturdemodulator erfährt, wird bei der Erfindung durch eine inverse Verformung des Quadraturdemodulatorsignals wieder kompensiert. Dadurch ändert sich die Differenzspannung an den beiden Diodenzweigen linear als Funktion der Frequenzabweichung des zu demodulierenden Eingangssignals von einem Nennwert. Zur weiteren linearen Verstärkung dieses Ausgangssignals ist den Diodenzweigen selbstverständlich ein linearer Verstärker nachgeschaltet.

Die Erfindung wird nachstehend anhand der Zeichnungen näher erläutert. Es zeigen

Fig. 1 das Blockschaltbild eines erfindungsgemäßen FM-Empfängers,

Fig. 2a die Kennlinie des Quadraturdemodulators,

Fig. 2b die Kennlinie der nichtlinearen Schaltung zur Kompensation der Verzerrungen,

Fig. 3 eine bevorzugte Ausführungsform der Erfindung und

Fig. 4 den Verlauf des Klirrfaktors mit und ohne Kompensation der Verzerrungen.

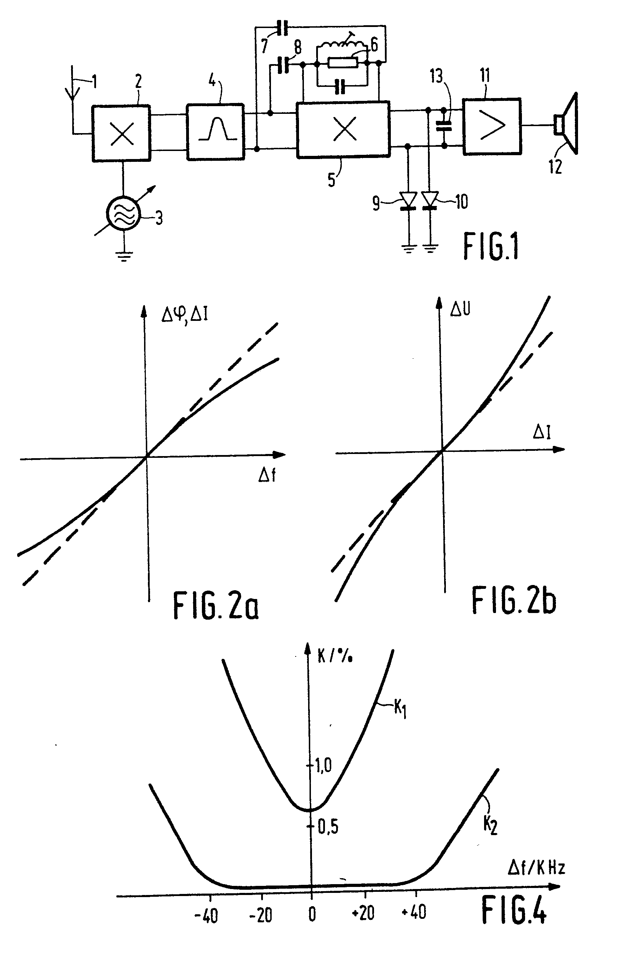

Gemäß Fig. 1 wird das von einer Antenne 1 gelieferte Signal einer Hochfrequenz-Mischstufe 2 zugeführt, in der es mit Hilfe eines abstimmbaren Oszillators 3 in eine Zwischenfrequenz von z.B. 10,7 MHz umgesetzt wird. Das Ausgangssignal der Mischstufe 2 wird in einem Zwischenfrequenzverstärker 4 verstärkt und, vorzugsweise über einen nicht näher dargestellten Begrenzerverstärker, einem FM-Quadraturdemodulator zugeführt. Der FM-Quadraturdemodulator umfaßt eine Multiplizierstufe 5, die an ihrem hochohmigen Ausgang ein Gegentaktsignal erzeugt (d.h. die Summe der Ausgangsströme ist konstant), das dem Produkt der an den Eingängen der Multiplizierstufe 5 anliegenden Spannungen proportional ist, und ein Phasendrehglied, das eine frequenzabhängige Phasenverschiebung zwischen den den beiden Eingängen der Multiplizierstufe 5 zugeführten Spannungen erzeugt. Das Phasendrehglied besteht aus einem Parallelresonanzkreis 6 mit einer Kreisgüte Q=20, dessen Anschlüsse mit den Ausgängen des ZF-Verstärkers 4 über zwei Kondensatoren 7 und 8 verbunden sind, deren Kapazität etwa 15 mal kleiner ist als die Kapazität des im Parallelresonanzkreis enthaltenen Kondensators. Die Spannung am Parallelresonanzkreis 6 wird in der Multiplizierstufe 5 mit der Spannung am Ausgang des ZF-Verstärkers 4 multipliziert. Der Parallelresonanzkreis ist so abgeglichen, daß sich bei der Zwischenfrequenz (10,7 MHz) ein Minimum des Klirrfaktors zweiter Ordnung ergibt. Ein derartiger FM-Quadraturdemodulator ist aus dem Valvo-Datenbuch 1983 "Integrierte Analogschaltungen für Rundfunk und NF-Anwendungen" Seite 340 bekannt.

Die beiden Gegentakt-Ausgangsklemmen des FM-Demodulators sind über zwei in Durchlaßrichtung gepolte Dioden 9 und 10 mit Masse verbunden sowie mit den Eingangsklemmen eines linearen Verstärkers 11, an dessen Ausgang ein Lautsprecher 12 angeschlossen ist und zwischen dessen Eingangsklemmen ein Kondensator 13 angeschlossen ist, der die Demodulationsprodukte mit der doppelten Zwischenfrequenz kurzschließt. Die von der Multiplizierstufe 5 gelieferten Ströme, die aus einem Gleich- und einem kleineren Niederfrequenzanteil bestehen, fließen, weil der Eingangswiderstand des linearen Verstärkers 11 groß ist, vollständig über die Dioden 9 bzw. 10 und erzeugen an diesen eine Differenzspannung, die vom Verstärker 11, der aus verschiedenen linearen Stufen bestehen kann, verstärkt und dem Lautsprecher 12 zugeführt wird.

Die Wirkung der Erfindung kann anhand der Fig. 2a und 2b verstanden werden. Fig. 2a stellt die Demodulatorkennlinie dar, d.h. sie zeigt die Abhängigkeit der vom Phasendrehglied erzeugten Phasendrehung $\Delta\varphi$ bzw. der Ausgangsstromdifferenz $\Delta I$ von der Abweichung $\Delta f$ der Frequenz des zu demodulierenden Signals von dem Mittenwert (10,7 MHz). Zur Verdeutlichung ist in gestrichelten Linien die Kennlinie eingezeichnet, die der Quadraturdemodulator haben müßte, wenn er verzerrungsfrei arbeiten sollte. Man erkennt, daß bei größeren Verstimmungen der Betrag der Steigung abnimmt.

Den Dioden 9 und 10 werden Gleichströme zugeführt, deren Differenz $\Delta I$ beträgt. Dadurch wird an den Dioden eine Differenzspannung $\Delta U$ hervorgerufen, deren Abhängigkeit von dem Ausgangsstrom des FM-Demodulators $\Delta I$ in Fig. 2b dargestellt ist. Man erkennt, daß bei größeren Ausgangsstromdifferenzen der Betrag der Steigung zunimmt. Die Kennlinie nach Fig. 2b verläuft also invers zu der Kennlinie nach Fig. 2a, so daß die Spannungsdifferenz $\Delta U$ am Eingang des linearen Verstärkers 11 proportional der Abweichung $\Delta f$ von der Mittenfrequenz ist. Die durch den FM-Quadraturdemodulator 5 ... 8 erzeugten Verzerrungen werden also durch die entgegengerichteten Verzerrungen des Ausgangssignals an den Dioden 9, 10 kompensiert.

Das Ausmaß, in dem die Kompensation erfolgt, wird von der Güte des Parallelresonanzkreises 6, dem Wirkungsgrad der Multiplizierstufe sowie von den Diodenkennlinien bestimmt. Im allgemeinen haben diese Parameter nicht solche Werte, daß sich die bestmögliche Kompensation ergibt. Es ist daher erforderlich, die Kennlinie gemäß Fig. 2b den Erfordernissen der Kennlinie nach Fig. 2a anzupassen. Eine Verringerung der Nichtlinearität der Dioden kann beispielsweise dadurch erfolgen, daß beiden Diodenzweigen zusätzlich je ein Gleichstrom einer bestimmten Größe zugeführt wird; die Verzerrungen sind nämlich um so geringer, je kleiner die Stromdifferenz $\Delta I$ im Vergleich zu dem Gleichstrom durch diese Dioden ist. Statt dessen kann den Dioden auch noch je ein Widerstand in Serie geschaltet werden und die Differenz der Spannungen an den Serienschaltungen aus Widerstand und Diode ausgenutzt werden. Diese Lösung hat den Vorteil, daß der Gleichspannungsabfall an der Serienschaltung größer ist als der Gleichspannungsabfall an einer Diode allein, was die Weiterverarbeitung durch den linearen Verstärker 11 erleichtert.

Hingegen kann die Nichtlinearität dadurch vergrößert werden, daß der unveränderliche Gleichstromanteil durch die Dioden verringert wird, z.B. dadurch, daß den Dioden ein Widerstand oder eine geeignet gepolte Gleichstromquelle parallelgeschaltet wird. In diesem Fall wird das Verhältnis zwischen dem signalabhängigen Stromanteil $\Delta I$ und dem konstanten Gleichstrom durch beide Dioden vergrößert, was eine stärkere Nichtlinearität zur Folge hat.

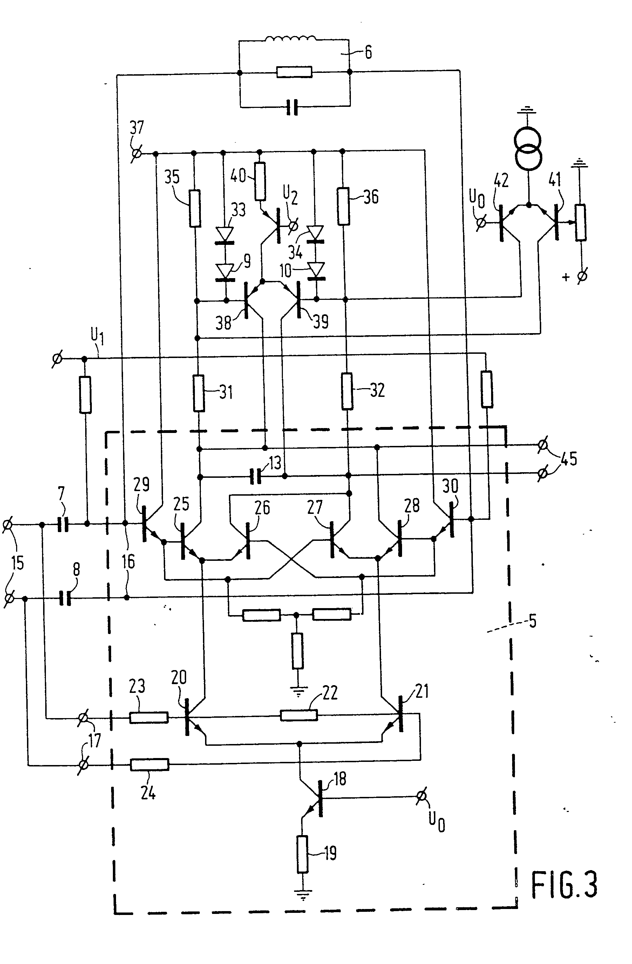

In Fig. 3 ist das Detail-Schaltbild einer Ausführungsform angegeben, die anstelle der Komponenten 5 ... 10 und 13 zwischen den Ausgang des Zwischenverstärkers 4 und den Eingang des linearen Verstärkers 11 geschaltet werden kann. Die an den Ausgang des ZF-Verstärkers 4 angeschlossenen Eingangsklemmen 15 der Schaltung sind direkt mit dem ersten Eingang 17 der Multiplizierstufe 5 verbunden und über die Kondensatoren 8 und 9 mit dem zweiten Eingang 16 der Multiplizierstufe 5, dem der Parallelkreis 6 mit einer Güte von etwa 20 parallelgeschaltet ist. Die Multiplizierstufe umfaßt eine Gleichstromquelle in Form eines npn-Transistors 18, dessen Emitter über einen Widerstand 19 mit Masse verbunden ist, dessen Basis an eine konstante Gleichspannung $U_o$ angeschlossen ist und dessen Kollektor mit den Emittern zweier weiterer npn-Transistor 20 und 21 verbunden ist, deren Basen über gleich große Widerstände 23 und 24 mit den Klemmen des ersten Einganges 17 verbunden sind. Zwischen die Basen ist ein Widerstand 22 geschaltet, der bewirkt, daß der Wechselanteil des Signals zwischen den Basen der Transistoren 21 und 22 immer nur ein Bruchteil des an den Klemmen 17 anliegenden Eingangssignals ist. Der Kollektor des Transistors 20 ist mit den Emittern zweier Transistoren 25 und 26 verbunden, während der Kollektor des Transistors 21 mit den Emittern zweier Transistoren 27 und 28 verbunden ist. Die Transitoren 25 bis 28 sind ebenfalls vom npn-Typ. Die miteinander verbundenen Basiselektroden der Transistoren 25 und 27 sind an den Ausgang einer Emitterfolgerstufe 29 angeschlossen, während die Basen der Transistoren 26 und 28 an den Ausgang einer Emitterfolgerstufe 30 angeschlossen sind.

Die miteinander verbundenen Kollektoren der Transistoren 26 und 27 einerseits und 25 und 28 andererseits bilden den mit dem Eingang des hochomigen linearen Verstärkers 11 verbundenen Ausgang 45 der Multiplizierstufe 5. An diese Ausgänge ist außerdem über je einen Widerstand 31 bzw. 32 die Serienschaltung zweier in Durchlaßrichtung betriebener Dioden 9 bzw. 33 und 10 bzw. 34 angeschlossen. Der andere Anschluß dieser Serienschaltung ist jeweils mit einer positiven Speisespannungsklemme 37 verbunden. Außerdem ist den beiden Serienschaltungen je ein Widerstand 35 bzw. 36 von parallelgeschaltet.

Die Spannungsdifferenz zwischen den beiden genannten Serienschaltungen ist mit den Basen zweier pnp-Transistoren 38 und 39 verbunden, in deren gemeinsame Emitterzuleitung eine Gleichstromquelle 40 geschaltet ist. Der Kollektor des Transistors 38 ist mit der gleichen Ausgangsklemme der Multiplizierstufe 5 verbunden, mit der auch seine Basis über den Widerstand 31 verbunden ist; ebenso ist der Kollektor des Transistors 39 und die (andere) Ausgangsklemme der Multiplizierstufe angeschlossen, mit der seine Basis über den Widerstand 32 verbunden ist.

Daß die Schaltung statt jeweils einer Diode 9 bzw. 10 jeweils zwei Dioden 9 und 33 bzw. 10 und 34 aufweist, hat zwei Gründe:

Zum einen werden damit die Vorspannungen für den Transistor 38 bzw. 39 und den die Stromquelle 40 bildenden Transistor erzeugt und zum anderen werden durch die zweite Diode (z.B. 33 bzw. 34) gerade die nichtlinearen Verzerrungen beseitigt, die sonst durch den nichtlinearen Zusammenhang zwischen der Basis-Emitter-Spannung der Transistoren 38, 39 und ihrem Kollekstrom hervorgerufen würden.

Das aus den Komponenten 9, 10 und 31...40 gebildete Netzwerk stellt einen nichtlinearen Zweipol dar, dessen differentieller Widerstand mit steigender Aussteuerung gemäß Fig. 2b zunimmt, so daß die durch den FM-Quadraturdemodulator 5 ... 9 hervorgerufenen Verzerrungen weitgehend kompensiert werden.

Bei einer Vergrößerung der Kreisgüte würden die Verzerrungen des FM-Quadraturdemodulators zunehmen; auch hierbei ließe sich ein Verzerrungsminimum dadurch erreichen, daß die Widerstände 35, 36 und/oder die Widerstände 31 und 32 durch geringere Widerstandswerte ersetzt würden. Statt dessen könnte auch der Strom der Stromquelle 40 vergrößert werden. Bei einer Verringerung der Kreisgüte müßten die Widerstände 31, 32 und/oder 35 und 36 vergrößert werden oder es müßte der Strom durch die Stromquelle 40 verringert werden.

Wenn durch die Multiplizierstufe 5 eine zusätzliche Phasendrehung eingeführt würde, würde das dazu führen, daß bei der Mittenfrequenz ($\Delta f=0$)

eine von Null verschiedene Phasendifferenz bzw. eine von Null verschiedene Stromdifferenz vorhanden wäre. Dieser Offset kann mittels einer Schaltung beseitigt werden, die zwei NPN-Transistoren 41 und 42 umfaßt, deren Emitter über eine Stromquelle mit Masse verbunden sind und deren Kollektoren an je eine der Diodenzweige 9 und 33 bzw. 10 und 34 angeschlossen sind. Die Basis des einen Transistores, z.B. 42, ist an eine feste Gleichspannung angeschlossen und die Basis des Transistors 41 an den Abgriff eines an eine Gleichspannung geschalteten Potentiometers. Durch Verändern der Stellung des Potentiometerabgriffes kann das Verhältnis der den Diodenzweigen 9, 33 bzw. 10, 34 zugeführten Gleichströme so verändert werden, daß bei der Mittenfrequenz die Ausgangsspannung ΔU gerade Null wird.

Die Wirkung der erfindungsgemäßen Schaltung ergibt sich aus dem Diagramm der Fig. 4. Dabei ist mit $K_1$ der Verlauf des Klirrfaktors als Funktion der Verstimmung Δf bezeichnet, der sich bei einem Frequenzhub von 75 kHz und einem Niederfrequenzsignal von 1 kHz ergeben würde, wenn an den Ausgang der Multiplizierstufe ein lineares Widerstandsnetzwerk angeschlossen wäre. Man erkennt, daß selbst bei einer exakten Abstimmung der Klirrfaktor noch größer ist als 0,5% (bei einer Kreistgüte von 20). Je größer die Verstimmung wird, d.h. je größer der Unterschied zwischen der ZF-Mittenfrequenz und der Differenz von Sender- und Oszillatorfrequenz wird, desto stärker wächst der Klirrfaktor.

Die Kurve $K_2$ zeigt den Verlauf des Klirrfaktors bei der Schaltungsanordnung nach Fig. 3. Man erkennt, daß bis zu einer Verstimmung von +40 kHz der Klirrfaktor (bei einer Kreisgüte 20, einem Frequenzhub von 75 kHz und einer Niederfrequenz von 1 kHz) noch unter 0,1% bleibt.

**Patentansprüche**

1. FM-Quadraturdemodulator, in welchem mit Hilfe eines Schwingkreises (6) eine frequenzabhängige Phasenverschiebung zwischen den den beiden Eingängen einer Multiplizierstufe (5) zugeführten Signalen erzeugt wird, wobei die Summe der Ausgangsströme der Multiplizierstufe zumindest näherungsweise konstant ist und das Ausgangssignal aus der Differenz (ΔU) zwischen den Ausgangsspannungen der Multiplizierstufe abgeleitet wird, mit Mitteln zur Verringerung der durch die nichtlineare Phasenkennlinie des Schwingkreises bewirkten Verzerrungen, dadurch gekennzeichnet, daß die zur Verringerung der durch dit nichtlineare Phasenkennline des Schwingkreises bewirkten Verzerrungen vorgesehenen Mittel eine mit den Ausgangsströmen (ΔI) der Multiplizierstufe (5) gespeiste Schaltung sind, deren Ausgangsspannung (ΔU) als Funktion des Eingangsstromes (ΔI) wenigstens näherungsweise den inversen Verlauf hat wie die Amplitude der Ausgangsströme (ΔI) der Multiplizierstufe als Funktion der Frequenzabweichung (Δf) des zu demodulierenden Eingangsignals von einem Nennwert und die zwei entsprechend dimensionierte Diodenzweige (9, 10) umfaßt, wobei jeweils einer der Ausgangsströme der Multiplizierstufe einem der beiden Diodenzweige zugeführt und die Differenzspannung (ΔU) an den Diodenzweigen abgegriffen wird.

2. FM-Quadraturdemodulator nach Anspruch 1, dadurch gekennzeichnet, daß jeder Diodenzweig eine Diode (9 bzw. 10) aufweist, deren Strom exponentiell von der anliegenden Spannung abhängt.

3. FM-Quadraturdemodulator nach Anspruch 2, dadurch gekennzeichnet, daß jede Diode (9, 10) über einen Widerstand (31, 32) mit je einem der Ausgänge des FM-Quadraturdemodulators verbunden ist und daß als Ausgangssignal die Spannungsdifferenz am Ausgang des FM-Demodulators (5 ... 8) dient.

4. FM-Quadraturdemodulator nach einem der Ansprüche 2 oder 3, dadurch gekennzeichnet, daß den Dioden (9, 10) je ein Widerstand (35, 36) parallelgeschaltet ist.

5. FM-Quadraturdemodulator nach einem der Ansprüche 2 bis 4, dadurch gekennzeichnet, daß in Serie zu jeder Diode (9, 10) eine weitere Diode (33, 34) geschaltet ist, daß zwei Transistoren (38, 39) vorgesehen sind, deren miteinander verbundenen Emittern ein Gleichstrom zugeführt wird, daß die Basen der beiden Transistoren (38, 39) mit je einem der Diodenzweige (9, 33; 10, 34) verbunden sind, daß die Kollektoren der Transistoren mit den beiden Ausgängen des FM-Quadraturdemodulators verbunden sind, und daß das Ausgangssignal der Schaltung die an den Kollektoren der beiden Transistoren abnehmbare Differenzspannung (ΔU) ist.

6. FM-Quadraturdemodulator nach einem der Ansprüche 1 bis 5, dadurch gekennzeichnet, daß den beiden Diodenzweigen (9, 33; 10, 34) ein zusätzlicher Hilfsgleichstrom zuführbar ist und daß die Größe der Hilfsgleichströme und/oder das Verhältnis der Hilfsgleichströme veränderbar ist.

**Revendications**

1. Démodulateur FM en quadrature, dans lequel, à l'aide d'un circuit oscillant (6), un déphasage dépendant de la fréquence est produit entre les signaux appliqués aux deux entrées d'un étage multiplicateur (5), la somme des courants de sortie de l'étage multiplicateur étant qu moins approximativement constante et le signal de sortie étant déduit de la différence (ΔU) entre les tensions de sortie de l'étage multiplicateur, comportant des moyens pour réduire les distorsions induites par la caractéristique de phase non linéaire du circuit oscillant, caractérisé en ce que les moyens prévus pour réduire les distorsions induites par la caractéristique de phase non linéaire du circuit oscillant sont constitués par un circuit alimenté par les courants de sortie (ΔI) de l'étage multiplicateur (5), dont la tension de sortie (ΔU) a une évolution en fonction du courant d'entrée (ΔI) qui est au moins approximativement l'inverse de celle de l'amplitude des courants de sortie (ΔI) de l'étage multiplicateur en fonction de la déviation de fréquence (Δf) du signal d'entrée à démoduler d'une valeur nominale et qui comporte deux branches à diode (9, 10) dimensionnées de manière correspondante, un des courants de sortie de l'étage multiplicateur étant chaque fois appliqué à l'une des deux branches à diode et la tension différentielle (ΔU) étant prise sur les branches à diode.

2. Démodulateur FM en quadrature suivant la revendication 1, caractérisé en ce que chaque branche à diode comporte une diode (9 ou 10) dont le courant dépend de manière exponentielle de la tension appliquée.

3. Démodulateur FM en quadrature suivant la revendication 2, caractérisé en ce que chaque diode (9, 10) est connectée par l'intermédiaire d'une résistance (31, 32) chaque fois à l'une des sorties du démodulateur FM en quadrature et que la différence de tensions à la sortie du démodulateur FM (5 ... 8) sert de signal de sortie.

4. Démodulateur FM en quadrature suivant l'une ou l'autre des revendications 2 et 3, caractérisé en ce qu'une résistance (35, 36) est chaque fois connectée en parallèle avec les diodes (9, 10).

5. Démodulateur FM en quadrature suivant l'une quelconque des revendications 2 à 4, caractérisé en ce qu'une autre diode (33, 34) est connectée en série avec chaque diode (9, 10), que deux transistors (38, 39) aux émetteurs interconnectés desquels est appliqué un courant continu sont prévus, que les bases des deux transistors (38, 39) sont connectées chaque fois à l'une des branches à diodes (9, 33; 10, 34), que les collecteurs des transistors sont connectés aux deux sorties du démodulateur FM en quadrature et que le signal de sortie du circuit est la tension différentielle (ΔU) pouvant être prise sur les collecteurs des deux transistors.

6. Démodulateur FM en quadrature suivant l'une quelconque des revendications 1 à 5, caractérisé en ce qu'un courant continu auxiliaire peut être appliqué aux deux branches à diodes (9, 33; 10, 34) et que la valeur des courants continus auxiliaires et/ou le rapport des courants continus auxiliaires peuvent être modifiés.

**Claims**

1. An FM quadrature demodulator, in which a resonant circuit (6) is used to generate a frequency-dependent phase shift between the signals applied to the two inputs of a multiplier stage (5), in which the sum of the output currents of the multiplier stage is at least substantially constant, and the output signal is derived from the difference (ΔU) between the output voltages of the multiplier stage, provided with means for reducing the distortions caused by the non-linear phase characteristic of the resonant circuit, characterized in that the means provided for reducing the distortions caused by the non-linear phase characteristic of the resonant circuit is a circuit which is fed with the output currents (ΔI) of the multiplier stage (5) and whose output voltage (ΔU) as a function of the input current (ΔI) has at least substantially a waveform which is inverse to that of the amplitude of the output currents (ΔI) of the multiplier stage as a function of the frequency deviation (Δf) from a nominal value of the input signal to be demodulated, and which circuit comprises two correspondingly dimensioned diode branches (9, 10), one of the output currents of the multiplier stage being each time applied to one of the two diode branches and the differential voltage (ΔU) being tapped from the diode branches.

2. An FM quadrature demodulator as claimed in Claim 1, characterized in that each diode branch has a diode (9 or 10) whose current depends exponentially on the applied voltage.

3. An FM quadrature demodulator as claimed in Claim 2, characterized in that each diode (9, 10) is connected via a resistor (31, 32) to one of the outputs of the FM quadrature demodulator and in that the voltage difference at the output of the FM demodulator (5 ... 8) serves as the output signal.

4. An FM quadrature demodulator as claimed in any one of Claims 2 or 3, characterized in that a resistor (35, 36) is connected in parallel with each of the diodes (9, 10).

5. An FM quadrature demodulator as claimed in any one of Claims 2 to 4, characterized in that a further diode (33, 34) is connected in series with each diode (9, 10), in that two transistors (38, 39) are provided, whose interconnected emitters receive a direct voltage, in that the bases of the two transistors (38, 39) are each connected to one of the diode branches (9, 33; 10, 34), in that the collectors of the transistors are connected to the two outputs of the FM quadrature demodulator, and in that the output signal of the circuit is the differential voltage (ΔU) which can be taken off from the collectors of the two transistors.

6. An FM quadrature demodulator as claimed in any one of Claims 1 to 5, characterized in that an additional auxiliary direct current can be applied to the two diode branches (9, 33; 10, 34) and in that the size of the auxiliary direct currents and/or the ratio of the auxiliary direct currents is variable.

FIG.1

FIG.2a

FIG.2b

FIG.4

FIG.3